# EUROPEAN PATENT SPECIFICATION

(11) **EP 3 995 310 B1**
(45) Date of publication and mention of the grant of the patent: **22.11.2023**
(21) Application number: 20865888.0
(22) Date of filing: 10.09.2020
(51) Int. Cl.: H04M 1/02, H01Q 1/24, H01Q 1/40

(54) **HOUSING ASSEMBLY AND PREPARATION METHOD THEREFOF, AND ELECTRONIC DEVICE**
GEHÄUSEANORDNUNG UND HERSTELLUNGSVERFAHREN DAFÜR SOWIE ELEKTRONISCHE VORRICHTUNG
ENSEMBLE COQUE ET SON PROCÉDÉ DE PRÉPARATION, ET DISPOSITIF ÉLECTRONIQUE

(30) Priority: 18.09.2019 CN 201910882948
(43) Date of publication of application: 11.05.2022
(73) Proprietor: GUANGDONG OPPO MOBILE TELECOMMUNICATIONS CORP., LTD., Dongguan, Guangdong 523860 (CN)
(72) Inventor: YANG, Xin, Dongguan, Guangdong 523860 (CN)
(74) Representative: Thorniley, Peter
(86) International application number: PCT/CN2020/114381
(87) International publication number: WO 2021/052234

(56) References cited:
- CN-A- 105 530 786
- CN-A- 105 658 008
- CN-A- 105 658 008
- CN-A- 106 987 803
- US-A1- 2009 110 854
- US-A1- 2019 223 311

## Description

### FIELD

The present disclosure relates to the field of electronic devices, and more particularly, to a housing assembly and a manufacturing method thereof, and an electronic device.

### BACKGROUND

Generally, it is simple and costs low to fabricate a housing of a mobile phone with plastic. However, the plastic housing has poor mechanical properties and is susceptible to damages. With the popularization of smart phones, more researches have been made to improve the mechanical properties of smart phone housings by adding metallic materials to the smart phone housings. In order to arrange an antenna or antenna feed points in a smart phone, a strip of an injection molding nano material is formed on the smart phone housing. However, the nano injection molding material and the metallic materials are quite different in color and glossiness, which destroys the appearance consistency of the housing. US2019/223311A1 discloses a metal enclosure of a mobile device, a production method for the metal enclosure, and a mobile device. US2009/110854A1 provides an exemplary housing includes a metallic glass main body; and two coatings formed on the metallic glass main body. CN105658008Arelates to a metal casing of communication device and a preparation method thereof, and a communication device using the metal casing.

### SUMMARY

In view of this, it is urgent to provide a housing assembly and a manufacturing method thereof, and an electronic device.

The housing assembly includes: a substrate having a display surface, where a penetrating accommodation hole is defined in the substrate, and an opening of the accommodation hole is located on the display surface; a plastic member disposed in the accommodation hole and fixedly connected to the substrate; and a covering layer covering an entirety of the display surface and shielding the opening of the accommodation hole located on the display surface. The housing assembly further includes a spacing unit disposed between the display surface and the covering layer, the spacing unit shielding the opening of the accommodation hole located on the display surface. The spacing unit includes an isolation layer disposed between the display surface and the covering layer, and a spacing layer disposed between the isolation layer and the covering layer. The spacing layer has a smaller density than the isolation layer.

The manufacturing method of a housing assembly includes: providing a substrate having a display surface, where a penetrating accommodation hole is defined in the substrate, and an opening of the accommodation hole is located on the display surface; disposing a plastic member in the accommodation hole, the plastic member being fixedly connected to the substrate; and forming a covering layer on the display surface to obtain the housing assembly, the covering layer shielding the opening of the accommodation hole located on the display surface. Said forming the covering layer on the display surface includes: forming a spacing unit on the display surface by adopting a deposition process, wherein the spacing unit is configured to shield the opening of the accommodation hole located on the display surface; and spraying a ceramic material on the spacing unit to form the covering layer, wherein the covering layer is located on a side of the spacing unit facing away from the substrate, said forming the spacing unit on the display surface by adopting the deposition process includes: forming an isolation layer on the display surface by adopting a physical vapor deposition process; and forming a spacing layer on the isolation layer by adopting a chemical vapor deposition process to obtain the spacing unit, wherein the spacing layer is located on a side of the isolation layer facing away from the display surface. The spacing layer has a smaller density than the isolation layer.

The electronic device includes: the above-mentioned housing assembly; a display assembly connected to the housing assembly, a mounting space being defined between the display assembly and the housing assembly; and a circuit board disposed in the mounting space and electrically connected to the display assembly.

The electronic device includes a display assembly, and a housing assembly including a side wall, a plastic member, and a covering layer. The side wall is arranged on an outer periphery of the display assembly. A penetrating accommodation hole is defined in the side wall. The plastic member is disposed in the accommodation hole and fixedly connected to the side wall. The covering layer covers the accommodation hole and the plastic member, and is made of a ceramic material.

### BRIEF DESCRIPTION OF DRAWINGS

In order to clearly explain technical solutions of embodiments of the present disclosure or in the related art, drawings used in the description of the embodiments or the related art are briefly described below. Obviously, the drawings as described below are merely some embodiments of the present disclosure. Based on these drawings, other drawings can be obtained by those skilled in the art without paying creative efforts.
FIG. 1 is a schematic structural diagram of an electronic device according to an embodiment.
FIG. 2 is a schematic structural diagram of a housing assembly of an electronic device illustrated in FIG. 1.
FIG. 3 is a cross-sectional view of a part of a housing assembly illustrated in FIG. 1 taken along line II-II.
FIG. 4 is a schematic structural diagram of a substrate and plastic members of an electronic device illustrated in FIG. 2.
FIG. 5 is a schematic structural diagram of a substrate and plastic members of an electronic device illustrated in FIG. 4 observed from another angle.
FIG. 6 is a schematic structural diagram of a substrate and plastic members of an electronic device illustrated in FIG. 5 observed from another angle.
FIG. 7 is a cross-sectional view of a part of a housing assembly of an electronic device according to another embodiment.
FIG. 8 is a cross-sectional view of a part of a housing assembly of an electronic device according to yet another embodiment.
FIG. 9 is a cross-sectional view of a part of a housing assembly of an electronic device according to still yet another embodiment.
FIG. 10 is a physical diagram of a housing assembly according to Embodiment 5.

### DESCRIPTION OF EMBODIMENTS

In order to explain the present disclosure, the present disclosure will be described in detail below with reference to the accompanying drawings. The accompanying drawings illustrate preferred embodiments of the present disclosure. However, the present disclosure can be implemented in many different forms and is not limited to the embodiments described herein. These embodiments are provided to facilitate a thorough and comprehensive understanding of the content of the present disclosure.

Unless otherwise defined, all technical and scientific terms used herein have the same meaning as commonly understood by those skilled in the technical field of the present disclosure. The terms used in the specification are only for the purpose of describing specific embodiments, and are not intended to limit the present disclosure.

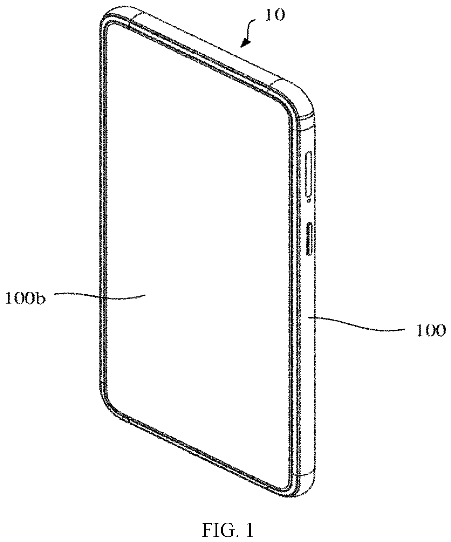

As illustrated in FIG. 1, an electronic device 10 according to an embodiment has relatively good signal receiving performance and a good appearance. The electronic device 10 includes a housing assembly 100 and a display assembly 100b. The display assembly 100b is connected to the housing assembly 100. When the electronic device 10 is operating normally, the display assembly 100b can display a pattern. A mounting space (not shown) is defined between the display assembly 100b and the housing assembly 100.

The electronic device 10 further includes a circuit board (not shown). A control circuit of the circuit board can control the normal operation of the electronic device 10. The circuit board is arranged in the mounting space and is electrically connected to the display assembly 100b. In an embodiment, the electronic device 10 can be any device capable of obtaining data from an outside and processing the data, or any device including a built-in battery and capable of obtaining currents from the outside to charge the battery. The electronic device 10 may be, for example, a mobile phone, a tablet computer, a computing device, or an information display device. In the illustrated embodiment, the electronic device 10 is a mobile phone. The housing assembly 100 is a middle frame of the mobile phone.

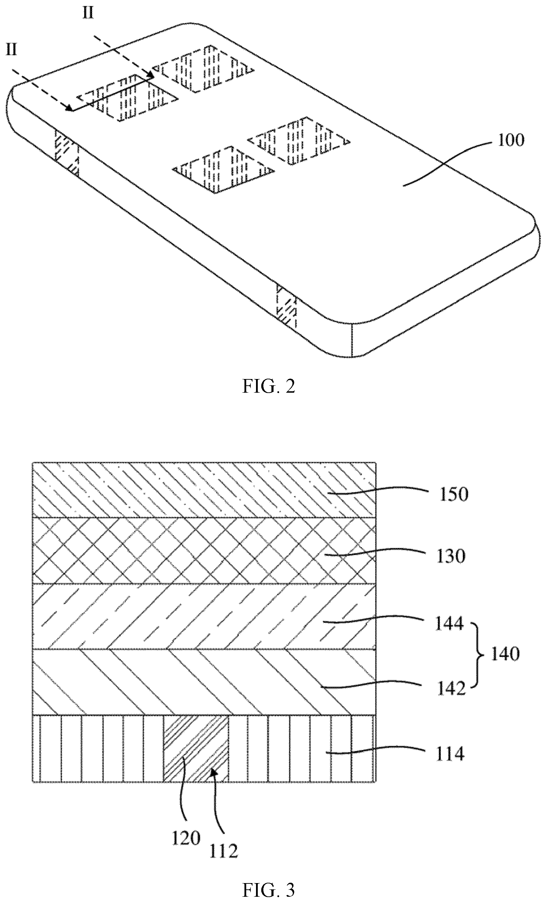

Referring to FIG. 2 to FIG. 4, the housing assembly 100 includes a substrate 110, a plastic member 120, and a covering layer 130. The substrate 110 has a display surface. A penetrating accommodation hole 112 is defined in the substrate 110, and an opening of the accommodation hole 112 is located on the display surface. The plastic member 120 is arranged in the accommodation hole 112 and fixedly connected to the substrate 110. The covering layer 130 is covering an entirety of the display surface and shielding the opening of the accommodation hole 112 located on the display surface.

The above housing assembly 100 includes the substrate 110, the plastic member 120, and the covering layer 130. The substrate 110 has the display surface. The penetrating accommodation hole 112 is defined in the substrate 110, the opening of the accommodation hole 112 is located on the display surface, and the plastic member 120 is arranged in the accommodation hole 112 and fixedly connected to the substrate 110. The covering layer 130 is covering an entirety of the display surface and shielding the opening of the accommodation hole 112 located on the display surface, so as to eliminate a difference in the appearances of the plastic member 120 and the substrate 110. In this way, the housing assembly 100 can have higher appearance consistency at the display surface.

In an embodiment, the accommodation hole 112 has a strip shape. It should be noted that the accommodation hole 112 may also be in a shape other than the strip shape, e.g., a circular shape. The accommodation hole 112 can be designed into any shape as required.

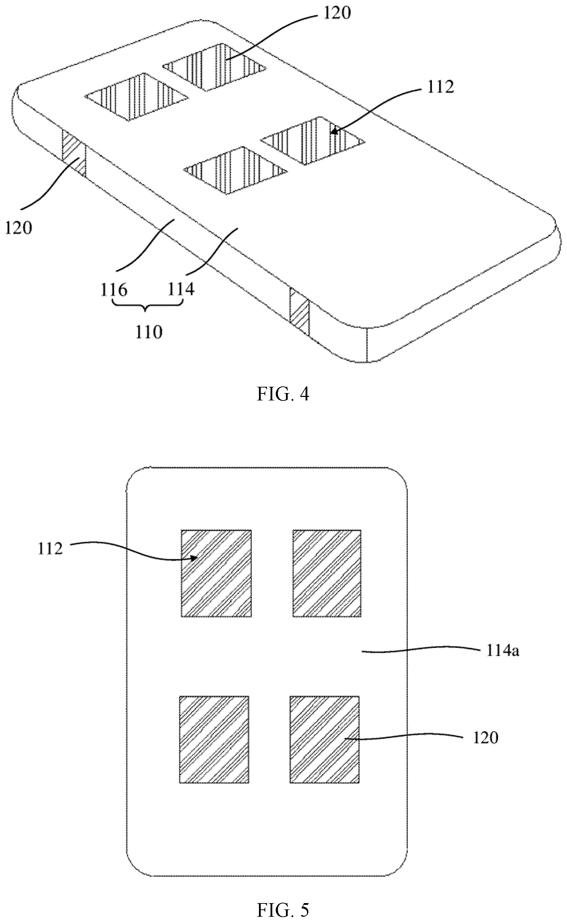

Referring to FIG. 4 to FIG. 5, the substrate 110 includes a substrate body 114, and a side wall 116 disposed circumferentially along an edge of the substrate body 114. An accommodating chamber is defined by the substrate body 114 and the side wall 116. The display assembly 100b is disposed to cover a side of the substrate 110 facing away from the covering layer 130 and is configured to shield the accommodating chamber. A mounting space is defined by the display assembly 100b and the substrate 110. At least one of the substrate body 114 and the side wall 116 has the display surface. Further, the substrate body 114 has a first surface 114a and a second surface that are opposite to each other (not shown). The side wall 116 is arranged on the second surface.

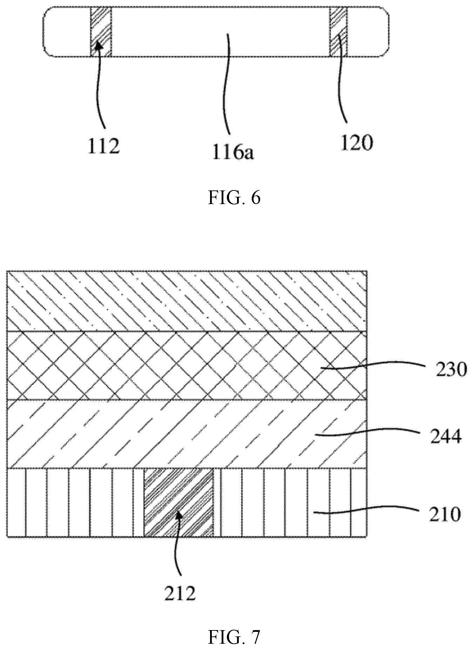

Further, referring to FIG. 5 and FIG. 6, provided is a plurality of accommodation holes 112 that are spaced apart from each other. A plurality of display surfaces is provided. Each display surface corresponds to an opening of one accommodation hole 112. Specifically, a first surface 114a and an outer surface 116a of the side wall 116 are both the display surfaces. Some of the accommodation holes 112 are provided on the substrate body 114 and penetrate both the first surface 114a and the second surface. The other accommodation holes 112 are provided on the side wall 116 and penetrate both the outer surface 116a and an inner surface (not shown) of the side wall 116.

In the illustrated embodiments, the substrate body 114 is a strip-shaped plate. The side wall 116 is arc-shaped. The substrate body 114 and the side wall 116 are formed as one piece. An accommodating chamber is enclosed by the second surface of the substrate body 114 and the inner surface of the side wall 116. It should be noted that the substrate body 114 and the side wall 116 are not limited to being formed as one piece, and may also be detachably connected to each other.

In an embodiment, the substrate 110 is made of a metallic material. For example, the substrate 110 is made of an aluminum alloy, a magnesium alloy, a titanium alloy, or stainless steel.

Further, the plastic member 120 is received in the accommodation hole 112. Furthermore, the plastic member 120 is formed in the accommodation hole 112 through a nano injection molding of the substrate 110.

In an embodiment, the plastic member 120 is made of a nano injection molding material. Further, the plastic member 120 is made of polybutylene terephthalate (PBT) or polyphenylene sulfide (PPS).

In an embodiment, a plurality of plastic members 120 is provided. The plurality of plastic members 120 is arranged in the plurality of accommodation holes 112 in one-to-one correspondence.

The covering layer 130 can eliminate the appearances difference between the plastic member 120 and the substrate 110, such that the housing assembly 100 has higher appearance consistency. Further, the covering layer 130 is configured to shield the opening of each accommodation hole 112 on the display surface. Furthermore, the covering layer 130 is configured to completely cover the first surface 114a of the substrate body 114 and the outer surface 116a of the side wall 116.

In an embodiment, the covering layer 130 is made of a ceramic material, so as to eliminate the appearances difference between the plastic member 120 and the substrate 110. In this way, the housing assembly 100 can have higher appearance consistency as well as the enhanced heat dissipation performance and mechanical strength, while the housing assembly 100 can have a ceramic texture and present a better appearance. In addition, the covering layer 130 may be provided with different colors by selecting different ceramic materials, such that the housing assembly 100 can exhibit a ceramic appearance of various colors. A color of the covering layer 130 may be, e.g., black, white, red, blue, or the like. It should be noted that the color of the covering layer 130 is not limited to any of the above colors and can be any color as required.

Further, the covering layer 130 is made of a material selected from at least one of zirconium dioxide (ZrO₂), yttrium oxide (Y₂O₃), titanium dioxide (TiO₂), aluminum oxide (Al₂O₃), doped ZrO₂, doped Y₂O₃, doped TiO₂, or doped Al₂O₃. Among them, the doped ZrO₂, the doped Y₂O₃, the doped TiO₂, and the doped Al₂O₃ represent metallic ion-doped ZrO₂, metallic ion-doped Y₂O₃, metallic ion-doped TiO₂, and metallic ion-doped Al₂O₃, respectively. The doped metallic ion may be, for example, at least one of strontium (Sr) ion, barium (Ba) ion, ytterbium (Yb) ion, niobium (Nb) ion, plumbum (Pb) ion, bismuth (Bi) ion, and the like. It should be noted that the above doped substances are not limited to metallic ions and may also be other ions. It should be noted that the covering layer 130 is not limited to being made of the ceramic material as described above, and it can also be made of any ceramic material as required.

In an embodiment, the covering layer 130 has a thickness ranging from 40 µm to 300 µm, which guarantees a thin thickness of the housing assembly 100 and the mechanical properties of the housing assembly 100. Further, the thickness of the covering layer 130 ranges from 40 µm to 120 µm, which can also ensure the thin thickness and the mechanical properties of the housing assembly 100.

The housing assembly 100 further includes a spacing unit 140. The spacing unit 140 is disposed between the display surface and the covering layer 130, and configured to shield the opening of the accommodation hole 112 located on the display surface. By disposing the spacing unit 140 between the display surface and the covering layer 130, the spacing unit 140 can protect the plastic member 120, the substrate 110, and a connection between the plastic member 120 and the substrate 110, and can also improve the adhesion of the covering layer 130.

In an embodiment, in which a plurality of accommodation holes 112 is provided, the spacing unit 140 is configured to shield the opening of each accommodation hole 112 located on the display surface. Further, the spacing unit 140 may cover the entire display surface. Furthermore, the spacing unit 140 may also cover the entire first surface 114a of the substrate body 114 and the entire outer surface 116a of the side wall 116.

In an embodiment, the spacing unit 140 is made of a material selected from at least one of aluminum nitride, aluminum oxide, silicon nitride, silicon dioxide, titanium nitride, silicon carbide, titanium carbide, or chromium carbide, such that the spacing unit 140 can have higher wear resistance and corrosion resistance, and can better protect the plastic member 120, the substrate 110, and the connection between the plastic member 120 and the substrate 110. It should be noted that the spacing unit 140 is not limited to being made of the materials described above and may also be made of other materials as required.

The spacing unit 140 includes an isolation layer 142 disposed between the display surface and the covering layer 130. The isolation layer 142 is configured to shield the opening of the accommodation hole 112 located on the display surface. The isolation layer 142 disposed between the display surface and the covering layer 130 can protect the plastic member 120, the substrate 110, and the connection between the plastic member 120 and the substrate 110. Furthermore, the isolation layer 142 may cover the entire display surface. Specifically, the isolation layer 142 may cover the entire first surface 114a of the substrate body 114 and the entire outer surface 116a of the side wall 116.

In an embodiment, the isolation layer 142 is made of a material selected from at least one of aluminum nitride, aluminum oxide, silicon nitride, silicon dioxide, titanium nitride, silicon carbide, titanium carbide, or chromium carbide. It should be noted that the isolation layer 142 is not limited to being made of the materials described above and may also be made of other materials as required.

In an embodiment, the isolation layer 142 has a thickness ranging from 0.01 µm to 5 µm. Further, the thickness of the isolation layer 142 may range from 0.5 µm to 1 µm. It should be noted that the thickness of the isolation layer 142 is not limited to the range described above and it may also fall within other ranges as required.

In an embodiment, the isolation layer 142 is formed by physical vapor deposition (PVD). By means of the PVD, the isolation layer 142 with a higher density can be obtained, such that the isolation layer 142 can have better heat insulation effect and mechanical properties, thereby enhancing the mechanical strength of the spacing unit 140.

The spacing unit 140 further includes a spacing layer 144 disposed between the isolation layer 142 and the covering layer 130. The spacing layer 144 can further enhance the mechanical strength of the spacing unit 140, so as to protect the plastic member 120, the substrate 110, and the connection between the plastic member 120 and the substrate 110, and improve the adhesion of the covering layer 130. Further, the spacing layer 144 may cover the entire isolation layer 142.

In an embodiment, the spacing layer 144 is made of a material selected from at least one of aluminum nitride, aluminum oxide, silicon nitride, silicon dioxide, titanium nitride, silicon carbide, titanium carbide, or chromium carbide. It should be noted that the spacing layer 144 is not limited to being made of the materials described above and it may also be made of other materials as required.

In an embodiment, the spacing layer 144 has a thickness ranging from 0.5 µm to 50 µm. Further, the thickness of the spacing layer 144 may range from 1 µm to 20 µm. It should be noted that the thickness of the spacing layer 144 is not limited to the range described above and it may also fall within other ranges as required.

According to the invention, the spacing layer 144 has a smaller density than the isolation layer 142. Since the isolation layer 142 has a higher density, the spacing unit 140 has better adhesiveness. Meanwhile, since the spacing layer 144 has a smaller density and a faster deposition speed, the spacing layer 144 has a smaller stress, thereby reducing an internal stress of the entire spacing unit 140.

In an embodiment, the spacing layer 144 is formed by chemical vapor deposition (CVD). The spacing layer 144 can be quickly deposited by means of the CVD, thereby improving the production efficiency. In addition, by means of the CVD, the density of the spacing layer 144 can be controlled to be smaller than the isolation layer 142, thereby enhancing an adhering capacity of the spacing unit 140 and improving the adhesion of the covering layer 130.

The housing assembly 100 further includes a functional film 150 arranged on a side of the covering layer 130 facing away from the substrate 110. The functional film 150 enables the housing assembly 100 to have a specific function or can improve the appearance of the housing assembly 100. Further, the functional film 150 is an anti-fingerprint film or an anti-glare (AG) film. It should be noted that the functional film 150 is not limited to any of the above examples, and can be selected as required.

To eliminate the appearances difference between the plastic and the substrate, some studies try to make the color of the nano injection molding material as close as possible to that of the substrate, or adopt a tiny slot design by changing a shape of the accommodation hole. However, it is still difficult to eliminate inconsistency caused by the plastic strip.

In the above embodiments, the housing assembly 100 includes the substrate 110, the plastic member 120, and the covering layer 130; the substrate 110 has the display surface, the penetrating accommodation hole 112 is defined in the substrate 110, the opening of the accommodation hole 112 is located on the display surface, the plastic member 120 is arranged in the accommodation hole 112 and fixedly connected to the substrate 110; the covering layer 130 is covering an entirety of the display surface and shielding the opening of the accommodation hole 112 located on the display surface. In this way, the appearances difference between the plastic member 120 and the substrate 110 can be eliminated, such that the housing assembly 100 can have higher appearance consistency at the display surface. Thus, the housing assembly 100 described above has the satisfying appearance consistency.

Further, the above housing assembly 100 can be used as a middle frame of a mobile phone, such that a plurality of antenna feed points can be arranged on the housing assembly 100 to transmit different signals.

It can be understood that a plurality of accommodation holes or one accommodation hole 112 may be provided. In this case, the accommodation hole 112 may be defined in the substrate body 114 or the side wall 116.

It can be understood that the spacing unit 140 may cover the entire display surface, or it may cover a part of the display surface and shield a part of the opening of the accommodation hole 112 located on the display surface.

It can be understood that the side wall 116 may be omitted. In this case, the housing assembly 100 can be used as a rear cover plate of the electronic device 10, e.g., the rear cover plate of a mobile phone. In addition, a housing of the electronic device 10 is formed by the housing assembly 100 along with a frame of the electronic device 10.

It can be understood that the isolation layer 142 may be omitted. In this case, referring to FIG. 7, a structure of the electronic device according to this embodiment is substantially the same as that of the electronic device 10 according to the above embodiments, except that the spacing unit includes merely a spacing layer 244. The spacing layer 244 is disposed between the display surface and the covering layer 230, and is configured to shield the opening of the accommodation hole 212 located on the display surface.

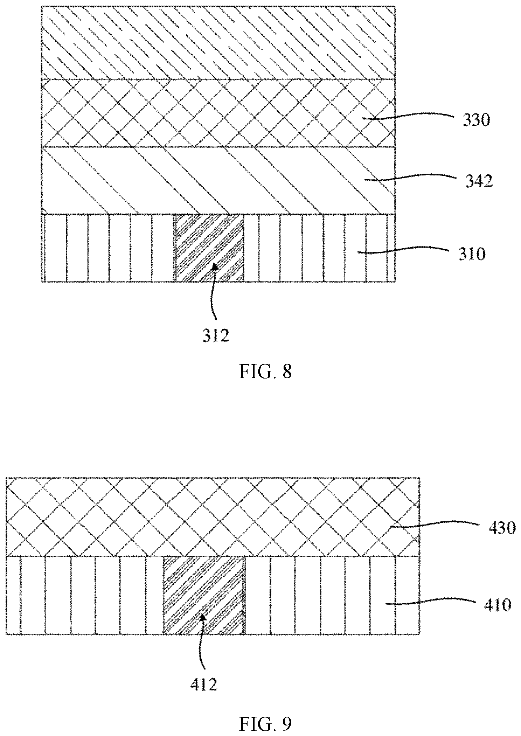

It can be understood that the spacing layer 144 may be omitted. In this case, referring to FIG. 8, a structure of the electronic device according to this embodiment is substantially the same as that of the electronic device 10 according to the above embodiments, except that the spacing unit includes merely an isolation layer 342. The isolation layer 342 is disposed between the display surface and the covering layer 330, and is configured to shield the opening of the accommodation hole 312 located on the display surface.

It can be understood that both the spacing unit 140 and the functional film layer 150 may be omitted. In this case, referring to FIG. 9, a covering layer 430 is disposed on a substrate 410. The covering layer 430 is covering an entirety of the display surface and shielding the entire accommodation hole 412.

Generally, the mechanical properties of the rear cover of the mobile phone can be improved by fabricating the rear cover of the mobile phone with a metallic material, such that the rear cover of the mobile phone is sturdy and durable, and the mobile phone is provided with a metallic and stylish appearance. However, the metallic material may interfere signal reception, which increases the difficulty of antenna design. It can be understood that the housing assembly 100 is not limited to the middle frame of the mobile phone, and the housing assembly 100 may also be the rear cover of the mobile phone. When the housing assembly 100 is the rear cover of the mobile phone, the antenna can be arranged in the accommodation hole 112, and the plastic member 120 enables signals to be radiated from the accommodation hole 112, thereby preventing the signals from being interfered by the metallic substrate 110.

In an embodiment, the electronic device 10 further includes an antenna (not shown). The antenna is accommodated in the mounting space. Further, the antenna accommodated in the mounting space is fixedly connected to the substrate 110 and close to the accommodation hole 112. Furthermore, a plurality of plastic members 120 and a plurality of accommodation holes 112 are provided. The plurality of plastic members 120 is disposed in the plurality of accommodation holes 112 in one-to-one correspondence. In this way, the antenna can be arranged in the accommodation holes 112 to enable signals to be radiated from the accommodation holes 112, thereby intensifying the signals of the electronic device 10.

In addition, referring to FIG. 1 to FIG. 6, a manufacturing method of the housing assembly 100 according to the above embodiments is provided. With the method, the housing assembly 100 with good appearance consistency can be prepared. The manufacturing method includes blocks S110 to S130.

At block S110, the substrate 110 having the display surface is provided, in which the penetrating accommodation hole 112 is defined in the substrate 110, and the opening of the accommodation hole 112 is located on the display surface.

It should be noted that the specific structure and material of the substrate 110 are described above in detail, which will not be repeated herein.

It should be noted that the substrate 110 is prepared by a conventional process. For example, the substrate 110 is prepared by performing a molding processing and a punching processing on a metallic plate. In another example, the substrate 110 is obtained by processing and splicing a plurality of metallic plates together.

At block S120, the plastic member 120 is arranged in the accommodation hole 112 and fixedly connected to the substrate 110.

It should be noted that the material and characteristics of the plastic member 120 are described above in detail, which will not be repeated herein.

In an embodiment, said disposing the plastic member 120 in the accommodation hole 112 includes performing nano injection molding on the substrate 110 to form the plastic member 120 in the accommodation hole 112. Further, the nano injection molding material is injected into the accommodation hole 112 in the substrate 110 to form the plastic member 120.

In an embodiment, subsequent to the block S 120, the method further includes a block of roughening the display surface of the substrate 110, which can improve the adhering capacity of the substrate 110, thereby improving the adhesion of a structure to be arranged on the display surface. Further, the roughened display surface has a surface roughness ranging from 0.5 µm to 10 µm. Furthermore, the surface roughness of the roughened display surface may range from 0.5 µm to 5 µm. The roughening process is a sandblasting process. It should be noted that, in addition to the sandblasting process, the roughening process may also be other roughening processes, e.g., chemical etching or a laser treatment. It should be noted that said roughening the display surface of the substrate 110 may be omitted.

At block S 130, the covering layer 130 is formed on the display surface to obtain the housing assembly 100. The covering layer 130 is configured to shield the opening of the accommodation hole 112 located on the display surface.

It should be noted that the specific structure and arrangement of the covering layer 130 are described above in detail, which will not be repeated herein.

In an embodiment, said forming the covering layer 130 on the display surface includes spraying a ceramic material on the display surface. In this way, the housing assembly 100 can have a ceramic texture without interfering with signals. In addition, the covering layer 130 of different colors can be obtained by selecting different ceramic materials, and thus the housing assembly 100 can have a variety of colors. The color of the covering layer 130 may be, for example, black, white, red, blue, and the like. It should be noted that, in addition to the above-mentioned colors, the covering layer 130 may have other colors as required. Further, said spraying can be a plasma spraying or a supersonic cold spraying. It should be noted that the spraying is not limited to any of the above examples, and it can be any other spraying methods. Furthermore, the layer obtained by the spraying has a thickness ranging from 50 µm to 300 µm.

Further, the ceramic material includes at least one of zirconium dioxide (ZrO₂), yttrium oxide (Y₂O₃), titanium dioxide (TiO₂), aluminum oxide (Al₂O₃), doped ZrO₂, doped Y₂O₃, doped TiO₂, or doped Al₂O₃. In the doped ZrO₂, the doped Y₂O₃, the doped TiO₂, and the doped Al₂O₃, metallic ions are doped. The doped metallic ion may be, for example, at least one of strontium (Sr) ion, barium (Ba) ion, ytterbium (Yb) ion, niobium (Nb) ion, plumbum (Pb) ion, bismuth (Bi) ion, and the like. It should be noted that the ceramic material is not limited to any of the above examples, and other ceramic materials may be adopted as required.

In an embodiment, said forming the covering layer 130 on the display surface includes: forming a spacing unit 140 on the display surface through a deposition process, in which the spacing unit is configured to shield the opening of the accommodation hole 112 located on the display surface; and spraying a ceramic material on the spacing unit 140 to form the covering layer 130, in which the covering layer 130 is located on a side of the spacing unit 140 facing away from the substrate 110.

Since the ceramic material is sprayed on the substrate at a relatively higher temperature, the substrate as well as the plastic member are likely to be deformed, and the deformed plastic member is likely to detach from the substrate 110. Thus, the appearance and use of the housing assembly may be affected. In the above embodiments, the spacing unit 140 is formed on the display surface and disposed between the display surface and the covering layer 130, and the spacing unit 140 is configured to shield the opening of the accommodation hole 112 located on the display surface. In this way, the spacing unit 140 can isolate heat, thereby alleviating the influence of heat on the substrate 110 and the plastic member 120, and preventing the plastic member 120 from being deformed due to the heat. Therefore, the substrate 110 and the plastic member 120 can be protected. In addition, by providing the spacing unit 140, a process window of ceramic spraying can be extended.

Further, the ceramic material includes at least one of zirconium dioxide (ZrO₂), yttrium oxide (Y₂O₃), titanium dioxide (TiO₂), aluminum oxide (Al₂O₃), doped ZrO₂, doped Y₂O₃, doped TiO₂, or doped Al₂O₃. In the doped ZrO₂, the doped Y₂O₃, the doped TiO₂, and the doped Al₂O₃, metallic ions are doped. The doped metallic ion may be, for example, at least one of strontium (Sr) ion, barium (Ba) ion, ytterbium (Yb) ion, niobium (Nb) ion, plumbum (Pb) ion, bismuth (Bi) ion, and the like. It should be noted that the ceramic material is not limited to any of the above examples, and other ceramic materials may be adopted as required.

In an embodiment, the spacing unit 140 is formed on the display surface by adopting a deposition process of PVD or CVD. Further, the PVD is a vacuum evaporation, a sputtering coating, or an ion plating. The CVD is a plasma enhanced chemical vapor deposition (PECVD) or a vacuum CVD.

In an embodiment, said forming the spacing unit 140 on the display surface by adopting the deposition process includes: forming an isolation layer 142 on the display surface by adopting the deposition process and forming a spacing layer 144 on a side of the isolation layer 142 facing away from the display surface by adopting the deposition process, so as to obtain the spacing unit 140. In this case, said spraying the ceramic material on the spacing unit 140 to form the covering layer 130 includes spraying the ceramic material on the spacing layer 144 to form the covering layer 130, in which the covering layer 130 is located on a side of the spacing layer 144 facing away from the substrate 110.

Further, the isolation layer 142 is configured to shield the opening of the accommodation hole 112 located on the display surface.

In an embodiment, the isolation layer 142 is made of a material selected from at least one of aluminum nitride, aluminum oxide, silicon nitride, silicon dioxide, titanium nitride, silicon carbide, titanium carbide, or chromium carbide.

In an embodiment, the isolation layer 142 has a thickness ranging from 0.01 µm to 5 µm. Further, the thickness of the isolation layer 142 may range from 0.5 µm to 1 µm.

In an embodiment, the isolation layer 142 is formed on the display surface by adopting a deposition process of PVD. The isolation layer 142 having a higher density can be obtained by adopting the PVD, such that the isolation layer 142 can have better heat insulation effect and mechanical properties, thereby enhancing the mechanical strength of the spacing unit 140. In addition, a deposition temperature of the PVD is relatively low, thereby avoiding the influence of high temperature on the substrate 110 and the plastic member 120. The PVD is a vacuum evaporation, a sputtering coating, or an ion plating.

Further, the deposition temperature ranges from 20°C to 180°C. Furthermore, the deposition temperature ranges from 20°C to 100°C.

In an embodiment, the spacing layer 144 is made of a material selected from at least one of aluminum nitride, aluminum oxide, silicon nitride, silicon dioxide, titanium nitride, silicon carbide, titanium carbide, or chromium carbide.

In an embodiment, the spacing layer 144 has a thickness ranging from 0.5 µm to 50 µm. Furthermore, the thickness of the spacing layer 144 may range from 1 µm to 20 µm.

In an embodiment, the spacing layer 144 has a smaller density than the isolation layer 142, which can enhance the adhering capacity of the spacing unit 140 and improve the adhesion of the covering layer 130.

In an embodiment, the spacing layer 144 is formed on the side of the isolation layer 142 facing away from the display surface by adopting a deposition process of CVD. The spacing layer 144 can be quickly deposited by using the CVD, thereby improving production efficiency. In addition, through the CVD, the density of the spacing layer 144 can be controlled to be smaller than that of the isolation layer 142, so as to enhance the adhering capacity of the spacing unit 140 and the adhesion of the covering layer 130. For example, when the deposition temperature is below 200°C, a relatively loose spacing layer 144 can be obtained. Further, the CVD is the PECVD or the vacuum CVD.

Further, the deposition temperature for forming the spacing layer 144 ranges from 150°C to 400°C. Furthermore, the deposition temperature for forming the spacing layer 144 ranges from 200°C to 300°C.

In an embodiment, subsequent to said forming the covering layer 130 on the display surface, the method further includes performing a surface treatment on a side of the covering layer 130 facing away from the substrate 110. Further, said performing the surface treatment includes forming a functional film 150 on the side of the covering layer 130 facing away from the substrate 110. Furthermore, the functional film 150 is an anti-fingerprint film or an AG film. It should be noted that, in addition to the above film materials, the functional film 150 may be made of any other film materials as required. It should be noted that in addition to the above-mentioned steps, said performing the surface treatment may also include other steps, for example, performing ceramic sealing treatment on the covering layer 130. It should be noted that the surface treatment performed on the side of the covering layer 130 facing away from the substrate 110 may be omitted.

In an embodiment, subsequent to said forming the covering layer 130 on the display surface and prior to said performing the surface treatment on the side of the covering layer 130 facing away from the substrate 110, the method further includes a polishing processing on the covering layer 130. The polishing processing can improve the glossiness of the covering layer 130. Further, the polishing processing is grinding. Furthermore, the polished covering layer 130 has a thickness ranging from 40 µm to 120 µm, which ensures a smaller thickness of the housing assembly 100 and guarantees the flatness and glossiness as well as the mechanical properties of the housing assembly 100. It should be noted that the polishing processing on the covering layer 130 may be omitted.

In the manufacturing method of the housing assembly 100 according to the above embodiments, the plastic member 120 is arranged in the accommodation hole 112, the plastic member 120 is fixedly connected to the substrate 110, the covering layer 130 is formed on the display surface and configured to shield the opening of the accommodation hole 112 located on the display surface. In this way, the appearances difference between the plastic member 120 and the substrate 110 can be eliminated, and thus the housing assembly 100 can have higher appearance consistency on the display surface. The above housing assembly 100 has better signal receiving performance and appearance consistency.

Further, in the manufacturing method of the housing assembly 100 described above, the covering layer 130 is formed by spraying the ceramic material on the display surface. In this way, the housing assembly 100 can be provided with a ceramic texture without interfering with signals. In addition, the covering layer 130 of different colors can be obtained by selecting different ceramic materials, and thus the housing assembly 100 can have a variety of color effects.

Further, in the manufacturing method of the housing assembly 100 described above, by adopting the PVD to form the isolation layer 142 between the display surface and the covering layer 130, the obtained isolation layer 142 can have a higher density, so as to enhance the mechanical strength of the spacing unit 140 and prevent the substrate 110 and the plastic part 120 from being affected by the high heat generated by the subsequence CVD for forming the spacing layer 144. By adopting the CVD to form the spacing layer 144 between the isolation layer 142 and the covering layer 130, the spacing layer 144 can be can quickly deposited to improve the production efficiency. In addition, by employing the CVD, the density of the spacing layer 144 can be controlled to be smaller than that of the isolation layer 142, thereby enhancing the adhering capacity of the spacing unit 140 and improving the adhesion of the covering layer 130.

In summary, the housing assembly 100 prepared by the manufacturing method according to the above embodiments can be used as a rear cover plate of a mobile phone. In this case, the antenna can be arranged in the accommodation hole 112, such that the signal can be radiated from the accommodation hole 112 to avoid interference to signals when the substrate 110 is a metallic substrate. In addition, the housing assembly 100 prepared by the manufacturing method according to the above embodiments can also be used as a middle frame of a mobile phone for disposing a plurality of antenna feed points on the housing assembly 100, in order to transmit different signals.

It can be understood that the block of forming the isolation layer 142 on the display surface may be omitted. In this case, referring to FIG. 7, the manufacturing method of the housing assembly according to another embodiment is substantially the same as the manufacturing method of the housing assembly 100 according to the above embodiments. The difference lies in that forming the covering layer 230 on the display surface includes: forming the spacing layer 244 on the display surface, the spacing layer 244 being configured to shield the opening of the accommodation hole 212 located on the display surface; and spraying the ceramic material on the spacing layer 244 to form the covering layer 230, which is located on the side of the spacing layer 244 facing away from the substrate 210. The spacing unit is composed of the spacing layer 244. The spacing layer 244 is disposed between the display surface and the covering layer 230 and is configured to shield the opening of the accommodation hole 212 located on the display surface.

It can be understood that the block of forming the spacing layer 144 on the side of the isolation layer 142 facing away from the display surface can be omitted. In this case, referring to FIG. 8, the manufacturing method of the housing assembly according to another embodiment is substantially the same as the manufacturing method of the housing assembly 100 according to the above embodiments. The difference lies in that forming the covering layer 330 on the display surface includes: forming the isolation layer 342 on the display surface, the isolation layer 342 being configured to shield the opening of the accommodation hole 312 located on the display surface; and spraying the ceramic material on the isolation layer 342 to form the covering layer 330, which is located on the side of the isolation layer 342 facing away from the substrate 310. The spacing unit is composed of the isolation layer 342. The isolation layer 342 is disposed between the display surface and the covering layer 330 and is configured to shield the opening of the accommodation hole 312 located on the display surface.

It can be understood that the block of forming the spacing unit 140 on the display surface may be omitted. In this case, forming the covering layer 130 on the display surface includes spraying the ceramic material on the display surface to form the covering layer 130, which is configured to shield the opening of the accommodation hole 112 located on the display surface.

The specific embodiments are described below.

Unless otherwise specified, in the following embodiments, the housing assembly is a middle frame of a mobile phone. The substrate is made of aluminum alloy steel. The plastic member is made of PBT.

### Example 1

The housing assembly according to the present example has a structure as illustrated in FIG. 1 to FIG. 5. A manufacturing process of the housing assembly according to the present example was as follows.
(1) A substrate having a display surface was provided. Penetrating accommodation holes were defined in the substrate, and an opening of the accommodation hole was located on the display surface.
(2) A plastic member was provided in the accommodation hole through a nano injection molding process, and the plastic member was fixedly connected to the substrate. The display surface of the substrate was roughened, and the roughened display surface had a surface roughness of 1 µm.
(3) An isolation layer was formed on the display surface through PVD to shield the entire display surface and the opening of the accommodation hole located on the display surface. The isolation layer was made of aluminum nitride and has a thickness of 0.01 µm. The deposition temperature was 20°C.
(4) A spacing layer was formed on a side of the isolation layer facing away from the display surface through CVD to obtain a spacing unit. The spacing layer was made of aluminum nitride. The spacing layer had a thickness of 0.5 µm. The deposition temperature was 150°C.
(5) A ceramic material was sprayed on a side of the spacing layer facing away from the substrate to form the covering layer. A spraying thickness was 50 µm. The ceramic material was ZrO₂.
(6) A side of the covering layer facing away from the spacing layer was polished to obtain the housing assembly. The polishing processing was grinding. The polished covering layer had a thickness of 40 µm.

### Example 2

The housing assembly according to the present example has a structure as illustrated in FIG. 1 to FIG. 5. A manufacturing process of the housing assembly according to the present example was as follows.
(1) A substrate having a display surface was provided. Penetrating accommodation holes were defined in the substrate, and an opening of the accommodation hole was located on the display surface.
(2) A plastic member was provided in the accommodation hole through a nano injection molding process, and the plastic member was fixedly connected to the substrate. The display surface of the substrate was roughened, and the roughened display surface had a surface roughness of 1 µm.
(3) An isolation layer was formed on the display surface through PVD to shield the entire display surface and the opening of the accommodation hole located on the display surface. The isolation layer was made of aluminum oxide and silicon nitride. The isolation layer had a thickness of 5 µm. The deposition temperature was 20°C.
(4) A spacing layer was formed on a side of the isolation layer facing away from the display surface through CVD to obtain a spacing unit. The spacing layer was made of silicon nitride. The spacing layer had a thickness of 50 µm. The deposition temperature was 150°C.
(5) A ceramic material was sprayed on a side of the spacing layer facing away from the substrate to form the covering layer. The spraying thickness was 300 µm. The ceramic material was Y₂O₃.
(6) A side of the covering layer facing away from the spacing layer was polished to obtain the housing assembly. The polishing processing was grinding. The polished covering layer had a thickness of 120 µm.

### Example 3

The housing assembly according to the present example has a structure as illustrated in FIG. 1 to FIG. 5. A manufacturing process of the housing assembly according to the present example was as follows.
(1) A substrate having a display surface was provided. Penetrating accommodation holes were defined in the substrate, and an opening of the accommodation hole was located on the display surface.
(2) A plastic member was provided in the accommodation hole through a nano injection molding process, and the plastic member was fixedly connected to the substrate. The display surface of the substrate was roughened, and the roughened display surface had a surface roughness of 1 µm.
(3) An isolation layer was formed on the display surface through PVD to shield the entire display surface and the opening of the accommodation hole located on the display surface. The isolation layer was made of silicon dioxide and had a thickness of 0.5 µm. The deposition temperature was 20°C.
(4) A spacing layer was formed on the side of the isolation layer facing away from the display surface through CVD to obtain a spacing unit. The spacing layer was made of titanium nitride. The spacing layer had a thickness of 1 µm. The deposition temperature was 200°C.
(5) A ceramic material was sprayed on a side of the spacing layer facing away from the substrate to form the covering layer. A spraying thickness was 90 µm. The ceramic material was the doped TiO₂, in which Nb ions were doped and a mass percentage of Nb ions was 5%.
(6) A side of the covering layer facing away from the spacing layer was polished to obtain the housing assembly. The polishing processing was grinding. The polished covering layer had a thickness of 60 µm.

### Example 4

The housing assembly according to the present example has a structure as illustrated in FIG. 1 to FIG. 5. A manufacturing process of the housing assembly according to the present example was as follows.
(1) A substrate having a display surface was provided. Penetrating accommodation holes were defined in the substrate, and an opening of the accommodation hole was located on the display surface.
(2) A plastic member was provided in the accommodation hole through a nano injection molding process, and the plastic member was fixedly connected to the substrate. The display surface of the substrate was roughened, and the roughened display surface had a surface roughness of 1 µm.
(3) An isolation layer was formed on the display surface through PVD to shield the entire display surface and the opening of the accommodation hole located on the display surface. The isolation layer was made of chromium carbide and had a thickness of 1 µm. The deposition temperature was 100°C.
(4) A spacing layer was formed on a side of the isolation layer facing away from the display surface through CVD to obtain a spacing unit. The spacing layer was made of titanium carbide. The spacing layer had a thickness of 20 µm. The deposition temperature was 300°C.
(5) A ceramic material was sprayed on a side of the spacing layer facing away from the substrate to form the covering layer. The spraying thickness was 230 µm. The ceramic material was the doped Al₂O₃, in which Yb ions were doped and a mass percentage of Yb ions was 8%.
(6) A side of the covering layer facing away from the spacing layer was polished to obtain the housing assembly. The polishing processing was grinding. The polished covering layer had a thickness of 100 µm.

### Example 5

The housing assembly according to the present example has a structure as illustrated in FIG. 1 to FIG. 5. A manufacturing process of the housing assembly according to the present example is as follows.
(1) A substrate having a display surface was provided. Penetrating accommodation holes were defined in the substrate, and an opening of the accommodation hole was located on the display surface.
(2) A plastic member was provided in the accommodation hole through a nano injection molding process, and the plastic member was fixedly connected to the substrate. The display surface of the substrate was roughened, and the roughened display surface had a surface roughness of 1 µm.
(3) An isolation layer was formed on the display surface through PVD to shield the entire display surface and the opening of the accommodation hole located on the display surface. The isolation layer was made of aluminum oxide and had a thickness of 0.75 µm. The deposition temperature was 80°C.
(4) A spacing layer was formed on a side of the isolation layer facing away from the display surface through CVD to obtain a spacing unit. The spacing layer was made of aluminum oxide. The spacing layer had a thickness of 10 µm. The deposition temperature of the spacing layer was 250°C.
(5) A ceramic material was sprayed on a side of the spacing layer facing away from the substrate to form the covering layer. The spraying thickness was 170 µm. The ceramic material was ZrO₂.
(6) A side of the covering layer facing away from the spacing layer was polished to obtain the housing assembly. The polishing processing was grinding. The polished covering layer had a thickness of 70 µm.

### Example 6

A structure of the housing assembly according to the present example is substantially the same as that in Example 5, except that the spacing unit is composed of the spacing layer. A manufacturing process of the housing assembly according to the present example was as follows.
(1) A substrate having a display surface was provided. Penetrating accommodation holes were defined in the substrate, and an opening of the accommodation hole was located on the display surface.
(2) A plastic member was provided in the accommodation hole through a nano injection molding process, and the plastic member was fixedly connected to the substrate. The display surface of the substrate was roughened, and the roughened display surface had a surface roughness of 1 µm.
(3) The spacing layer was formed on the display surface through CVD to obtain a spacing unit. The spacing unit was configured to shield the entire display surface and the opening of the accommodation hole located on the display surface. The spacing layer was made of aluminum oxide. The spacing layer had a thickness of 10 µm. The deposition temperature of the spacing layer was 250°C.
(4) A ceramic material was sprayed on the side of the spacing layer facing away from the substrate to form the covering layer. The spraying thickness was 170 µm. The ceramic material was ZrO₂.
(5) A side of the covering layer facing away from the spacing layer was polished to obtain the housing assembly. The polishing processing was grinding. The polished covering layer had a thickness of 70 µm.

### Example 7

A structure of the housing assembly according to the present example is substantially the same as that in Example 5, except that the spacing unit includes the isolation layer. A manufacturing process of the housing assembly according to the present example was as follows.
(1) A substrate having a display surface was provided. Penetrating accommodation holes were defined in the substrate, and an opening of the accommodation hole was located on the display surface.
(2) A plastic member was provided in the accommodation hole through a nano injection molding process, and the plastic member was fixedly connected to the substrate. The display surface of the substrate was roughened, and the roughened display surface had a surface roughness of 1 µm.
(3) An isolation layer was formed on the display surface through PVD to obtain a spacing unit. The spacing unit was configured to shield the entire display surface and the opening of the accommodation hole located on the display surface. The isolation layer was made of aluminum oxide. The isolation layer had a thickness of 0.75 µm. The deposition temperature was 80°C.
(4) A ceramic material was sprayed on the side of the isolation layer facing away from the substrate to form the covering layer. The spraying thickness was 170 µm. The ceramic material was ZrO₂.
(5) A side of the covering layer facing away from the isolation layer was polished to obtain the housing assembly. The polishing processing was grinding. The covering layer after the polishing treatment had a thickness of 70 µm.

### Example 8

A manufacturing process of the housing assembly according to the present example was substantially the same as that in Example 5, except that step (2) merely includes providing the plastic member in the accommodation hole through a nano injection molding process, in which the plastic member was fixedly connected to the substrate.

### Example 9

A structure of the housing assembly according to the present example is substantially the same as that in Example 5, except that no spacing unit was provided. A manufacturing process of the housing assembly according to the present example was as follows.
(1) A substrate having a display surface was provided. Penetrating accommodation holes were defined in the substrate, and an opening of the accommodation hole was located on the display surface.
(2) A plastic member was provided in the accommodation hole through a nano injection molding process, and the plastic member was fixedly connected to the substrate. The display surface of the substrate was roughened, and the roughened display surface had a surface roughness of 1 µm.
(3) A ceramic material was sprayed on the display surface to form the covering layer. The covering layer was configured to shield the entire display surface and the opening of the accommodation hole located on the display surface. The spraying thickness was 170 µm. The ceramic material was ZrO₂.
(4) A side of the covering layer facing away from the substrate was polished to obtain the housing assembly. The polishing processing was grinding. The polished covering layer had a thickness of 70 µm.

Tests are provided as follows.

### Test 1

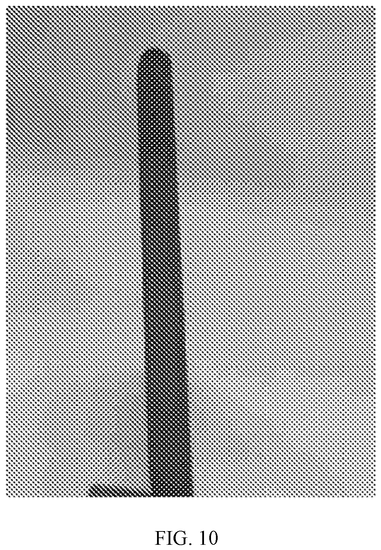

A photo of the housing assembly in Example 5 was taken, referring to FIG. 10.

It can be seen from FIG. 10 that, in Example 5, the nano injection molding material on the surface of the housing assembly and metallic material had no difference in color and glossiness, exhibited good appearance consistency. In addition, in Example 5, neither expansion nor deformation occurred on the surface of the housing assembly. Therefore, the housing assembly according to the above example has good appearance consistency, a smooth surface, and better use performance.

### Test 2

For the housing assembly according to Examples 1 to 9, the impact resistance of the housing assembly and the adhesion of the covering layer were measured. For the housing assembly according to Examples 1 to 8, the adhesion of a side of the spacing unit close to the substrate was additionally measured.

The impact resistance of the housing assembly was tested using a drop test. Specifically, four corners and four sides of the housing assembly, as impacting positions, hit the marble floor from a height of 0.8 m, respectively. The impact resistance was determined to be qualified and unqualified according to such criteria that the absence of debris with a diameter greater than 0.1 mm falling off from the housing assembly indicates "qualified", and the presence of the debris with a diameter greater than 0.1 mm falling off from the housing assembly indicated "unqualified".

The adhesion of the covering layer was tested with a trough vibrator manufactured by ROSLER (Germany). Specifically, during the test, the housing assembly was placed in a container with a volume of 15 L, 11 kg of yellow cones and 4 kg of green pyramids were mixed and added into the trough vibrator, and 1 L of water and 10 mL of lubricant were added into the trough vibrator. The objects in the container were stirred at a speed of 1,500 r/min. Test time (i.e., stirring time) was 2h. The adhesion was determined to be qualified and unqualified according to such criteria that the absence of debris with a diameter greater than 0.1 mm falling off from the housing assembly indicates "qualified", and the presence of the debris with a diameter greater than 0.1 mm falling off from the housing assembly indicated "unqualified".

During the manufacturing process of the housing assembly and before the covering layer was formed, the adhesion of the covering layer was tested with the trough vibrator manufactured by ROSLER (Germany). Specifically, during the test, the housing assembly was placed in a container with a volume of 15 L, 11 kg of yellow cones and 4 kg of green pyramids were mixed and added into the trough vibrator, and 1 L of water and 10 mL of lubricant were added into the trough vibrator. The objects in the container were stirred at a speed of 1,500 r/min. Test time (i.e., stirring time) was 2h. The adhesion was determined to be qualified and unqualified according to such criteria that the absence of debris with a diameter greater than 0.1 mm falling off from the housing assembly indicates "qualified", and the presence of the debris with a diameter greater than 0.1 mm falling off from the housing assembly indicated "unqualified".

Test results are shown in Table 1. Table 1 lists the impact resistance of the housing assembly and the adhesion of the covering layer according to Examples 1 to 9, and the adhesion of the side of the spacing unit close to the substrate in the housing assembly according to Examples 1 to 8.

**[Table 1]**

| | Impact resistance | Adhesion of covering layer | Adhesion of spacing unit |
|---|---|---|---|
| Example 1 | Qualified | Qualified | Qualified |
| Example 2 | Qualified | Qualified | Qualified |
| Example 3 | Qualified | Qualified | Qualified |
| Example 4 | Qualified | Qualified | Qualified |
| Example 5 | Qualified | Qualified | Qualified |
| Example 6 | Qualified | Qualified | Qualified |
| Example 7 | Qualified | Qualified | Qualified |
| Example 8 | Qualified | Qualified | Qualified |
| Example 9 | Qualified | -- | -- |

It can be seen from Table 1 that the impact resistance of the housing assembly according to any one of Examples 1 to 9 is "qualified", indicating that the housing assembly prepared according to any one of the above examples have good impact resistance; the adhesion of the covering layer according to any one of Examples 1 to 8 is "qualified", indicating that the covering layer of the housing assembly according to any one of the above examples has good adhesion; and the adhesion of the spacing unit according to any one of Examples 1 to 8 is "qualified", indicating that in the above examples, the good adhesion of the covering layer can be ensured in the presence of the spacing unit.

Technical features in the above embodiments can be combined arbitrarily. For concise description, not all possible combinations of the technical features in the above embodiments are described.

## Claims

1. A housing assembly (100), comprising:
a substrate (110) having a display surface, wherein a penetrating accommodation hole (112) is defined in the substrate (110), and an opening of the accommodation hole (112) is located on the display surface;
a plastic member (120) disposed in the accommodation hole (112) and fixedly connected to the substrate (110); and
a covering layer (130) covering an entirety of the display surface and shielding the opening of the accommodation hole (112) located on the display surface,
wherein the housing assembly (100) further comprises a spacing unit (140) disposed between the display surface and the covering layer (130), the spacing unit (140) shielding the opening of the accommodation hole (112) located on the display surface,
wherein the spacing unit (140) comprises an isolation layer (142) disposed between the display surface and the covering layer (130), and a spacing layer (144) disposed between the isolation layer (142) and the covering layer (130), **characterized in that**,
the spacing layer (144) has a smaller density than the isolation layer (142).

2. The housing assembly (100) according to claim 1, wherein the substrate (110) is made of a metallic material, optionally, the covering layer (130) is made of a ceramic material, and optionally, the covering layer (130) has a thickness ranging from 40 µm to 300 µm.

3. The housing assembly (100) according to claim 1, wherein a plurality of accommodation holes (112) that are spaced apart from each other and a plurality of plastic members (120) disposed in the plurality of accommodation holes (112) in one-to-one correspondence are provided, and the opening of each of the plurality of accommodation holes (112) located on the display surface is shielded by the covering layer (130).

4. The housing assembly (100) according to claim 1, wherein the spacing unit (140) is made of a material selected from at least one of aluminum nitride, aluminum oxide, silicon nitride, silicon dioxide, titanium nitride, silicon carbide, titanium carbide, or chromium carbide.

5. The housing assembly (100) according to claim 1, wherein the isolation layer is made of a material selected from at least one of aluminum nitride, aluminum oxide, silicon nitride, silicon dioxide, titanium nitride, silicon carbide, titanium carbide, or chromium carbide; and
optionally, the spacing layer (144) is made of a material selected from at least one of aluminum nitride, aluminum oxide, silicon nitride, silicon dioxide, titanium nitride, silicon carbide, titanium carbide, or chromium carbide.

6. The housing assembly (100) according to claim 5, wherein the isolation layer (142) has a thickness ranging from 0.01 µm to 5 µm;
optionally, the spacing layer (144) has a thickness ranging from 0.5 µm to 50 µm.

7. The housing assembly (100) according to any one of claims 1 to 6, further comprising a functional film (150) arranged on a side of the covering layer (130) facing away from the substrate (110).

8. A manufacturing method of a housing assembly (100), comprising:
providing a substrate (110) having a display surface, wherein a penetrating accommodation hole (112) is defined in the substrate (110), and an opening of the accommodation hole (112) is located on the display surface;
disposing a plastic member (120) in the accommodation hole (112), wherein the plastic member (120) is fixedly connected to the substrate (110); and
forming a covering layer (130) on the display surface to obtain the housing assembly (100), the covering layer (130) shielding the opening of the accommodation hole (112) located on the display surface,
wherein said forming the covering layer (130) on the display surface comprises:
forming a spacing unit (140) on the display surface by adopting a deposition process, wherein the spacing unit (140) is configured to shield the opening of the accommodation hole (112) located on the display surface; and
spraying a ceramic material on the spacing unit (140) to form the covering layer (130), wherein the covering layer (130) is located on a side of the spacing unit (140) facing away from the substrate (110), and
wherein said forming the spacing unit (140) on the display surface by adopting the deposition process comprises:
forming an isolation layer (142) on the display surface by adopting a physical vapor deposition process; and
forming a spacing layer (144) on the isolation layer (142) by adopting a chemical vapor deposition process to obtain the spacing unit (140), wherein the spacing layer (144) is located on a side of the isolation layer (142) facing away from the display surface,
**characterized in that**, the spacing layer (144) has a smaller density than the isolation layer (142).

9. The manufacturing method of the housing assembly (100) according to claim 8, wherein said forming the covering layer (130) on the display surface comprises:
spraying a ceramic material on the display surface to form the covering layer (130).

10. An electronic device (10), comprising:
the housing assembly (100) according to any one of claims 1 to 7 or the housing assembly (100) prepared by the manufacturing method of the housing assembly (100) according to claim 8 or 9;
a display assembly (100b) connected to the housing assembly (100), wherein a mounting space is defined between the display assembly (100b) and the housing assembly (100); and
a circuit board disposed in the mounting space and electrically connected to the display assembly (100b).

11. The electronic device (10) according to claim 10, further comprising an antenna accommodated in the mounting space, the antenna being close to the accommodation hole (112).

12. The electronic device (10) according to claim 10, wherein the housing assembly (100) comprising a side wall (116) arranged on an outer periphery of the display assembly (100b), the penetrating accommodation hole (112) is defined in the side wall (116), the plastic member (120) is disposed in the accommodation hole (112) and fixedly connected to the side wall (116), and the covering layer (130) covers the accommodation hole (112) and the plastic member (120), and the covering layer (130) is made of a ceramic material.

## Patentansprüche

1. Gehäuseanordnung (100), die Folgendes umfasst:
ein Substrat (110) mit einer Anzeigeoberfläche, wobei ein Aufnahmedurchgangsloch (112) in dem Substrat (110) definiert ist und sich eine Öffnung des Aufnahmelochs (112) auf der Anzeigeoberfläche befindet;
ein Kunststoffelement (120), das in dem Aufnahmeloch (112) angeordnet und fest mit dem Substrat (110) verbunden ist; und
eine Abdeckschicht (130), die die gesamte Anzeigeoberfläche bedeckt und die Öffnung des Aufnahmelochs (112), die sich auf der Anzeigeoberfläche befindet, abdeckt,
wobei die Gehäuseanordnung (100) ferner eine Abstandseinheit (140) umfasst, die zwischen der Anzeigeoberfläche und der Abdeckschicht (130) angeordnet ist, wobei die Abstandseinheit (140) die Öffnung des Aufnahmelochs (112), die sich auf der Anzeigeoberfläche befindet, abschirmt,
wobei die Abstandseinheit (140) eine Isolationsschicht (142), die zwischen der Anzeigeoberfläche und der Abdeckschicht (130) angeordnet ist, und eine Abstandsschicht (144), die zwischen der Isolationsschicht (142) und der Abdeckschicht (130) angeordnet ist, umfasst, **dadurch gekennzeichnet, dass**
die Abstandsschicht (144) eine geringere Dichte als die Isolierschicht (142) aufweist.

2. Gehäuseanordnung (100) nach Anspruch 1, wobei das Substrat (110) aus einem metallischen Material hergestellt ist die Abdeckschicht (130) optional aus einem keramischen Material hergestellt ist und die Abdeckschicht (130) optional eine Dicke im Bereich von 40 µm bis 300 µm aufweist.

3. Gehäuseanordnung (100) nach Anspruch 1, wobei mehrere Aufnahmelöcher (112), die voneinander beabstandet sind, und mehrere Kunststoffelemente (120), die in einer Eins-zu-eins-Beziehung in den mehreren Aufnahmelöchern (112) angeordnet sind, vorgesehen sind und die Öffnung jedes der mehreren Aufnahmelöcher (112), die sich auf der Anzeigeoberfläche befindet, durch die Abdeckschicht (130) abgeschirmt ist.

4. Gehäuseanordnung (100) nach Anspruch 1, wobei die Abstandseinheit (140) aus einem Material hergestellt ist, das aus wenigstens einem aus Aluminiumnitrid, Aluminiumoxid, Siliziumnitrid, Siliziumdioxid, Titannitrid, Siliziumkarbid, Titankarbid oder Chromkarbid ausgewählt ist.

5. Gehäuseanordnung (100) nach Anspruch 1, wobei die Isolationsschicht aus einem Material hergestellt ist, das aus wenigstens einem aus Aluminiumnitrid, Aluminiumoxid, Siliziumnitrid, Siliziumdioxid, Titannitrid, Siliziumkarbid, Titankarbid oder Chromkarbid ausgewählt ist; und
optional die Abstandsschicht (144) aus einem Material hergestellt ist, das aus wenigstens einem aus Aluminiumnitrid, Aluminiumoxid, Siliziumnitrid, Siliziumdioxid, Titannitrid, Siliziumkarbid, Titankarbid oder Chromkarbid ausgewählt ist.

6. Gehäuseanordnung (100) nach Anspruch 5, wobei die Isolierschicht (142) eine Dicke im Bereich von 0,01 µm bis 5 µm aufweist;
optional die Abstandsschicht (144) eine Dicke im Bereich von 0,5 µm bis 50 µm aufweist.

7. Gehäuseanordnung (100) nach einem der Ansprüche 1 bis 6, die ferner einen Funktionsfilm (150) umfasst, der auf einer vom Substrat (110) abgewandten Seite der Abdeckschicht (130) angeordnet ist.

8. Herstellungsverfahren für eine Gehäuseanordnung (100), das Folgendes umfasst:
Bereitstellen eines Substrats (110) mit einer Anzeigeoberfläche, wobei ein Aufnahmedurchgangsloch (112) in dem Substrat (110) definiert ist und sich eine Öffnung des Aufnahmelochs (112) auf der Anzeigeoberfläche befindet;
Anordnen eines Kunststoffelements (120) in der Aufnahmeöffnung (112), wobei das Kunststoffelement (120) fest mit dem Substrat (110) verbunden ist; und
Bilden einer Abdeckschicht (130) auf der Anzeigeoberfläche, um die Gehäuseanordnung (100) zu erhalten, wobei die Abdeckschicht (130) die Öffnung des Aufnahmelochs (112), die sich auf der Anzeigeoberfläche befindet, abschirmt,
wobei das Bilden der Abdeckschicht (130) auf der Anzeigeoberfläche Folgendes umfasst:
Bilden einer Abstandseinheit (140) auf der Anzeigeoberfläche durch Einsetzen eines Abscheidungsprozesses, wobei die Abstandseinheit (140) konfiguriert ist, die Öffnung des Aufnahmelochs (112), die sich auf der Anzeigeoberfläche befindet, abzuschirmen; und
Sprühen eines keramischen Materials auf die Abstandseinheit (140), um die Abdeckschicht (130) zu bilden, wobei sich die Abdeckschicht (130) auf einer von dem Substrat (110) abgewandten Seite der Abstandseinheit (140) befindet, und
wobei das Bilden der Abstandseinheit (140) auf der Anzeigeoberfläche durch Einsetzen des Abscheidungsprozesses Folgendes umfasst:
Bilden einer Isolationsschicht (142) auf der Anzeigeoberfläche durch Einsetzen eines physikalischen Gasphasenabscheidungsprozesses; und
Bilden einer Abstandsschicht (144) auf der Isolationsschicht (142) durch Einsetzen eines chemischen Gasphasenabscheidungsprozesses, um die Abstandseinheit (140) zu erhalten, wobei sich die Abstandsschicht (144) auf einer von der Anzeigeoberfläche abgewandten Seite der Isolationsschicht (142) befindet,
**dadurch gekennzeichnet, dass** die Abstandsschicht (144) eine geringere Dichte als die Isolierschicht (142) aufweist.

9. Herstellungsverfahren für die Gehäuseanordnung (100) nach Anspruch 8, wobei das Bilden der Abdeckschicht (130) auf der Anzeigeoberfläche Folgendes umfasst:
Sprühen eines keramischen Materials auf die Anzeigeoberfläche, um die Abdeckschicht (130) zu bilden.

10. Elektronische Vorrichtung (10), die Folgendes umfasst:
die Gehäuseanordnung (100) nach einem der Ansprüche 1 bis 7 oder die Gehäuseanordnung (100), die gemäß dem Herstellungsverfahren für die Gehäuseanordnung (100) nach Anspruch 8 oder 9 vorbereitet wurde;
eine Anzeigeanordnung (100b), die mit der Gehäuseanordnung (100) verbunden ist, wobei zwischen der Anzeigeanordnung (100b) und der Gehäuseanordnung (100) ein Montageraum definiert ist; und
eine Leiterplatte, die in dem Montageraum angeordnet und elektrisch mit der Anzeigeanordnung (100b) verbunden ist.

11. Elektronische Vorrichtung (10) nach Anspruch 10, die ferner eine im Montageraum untergebrachte Antenne umfasst, wobei sich die Antenne in der Nähe des Aufnahmelochs (112) befindet.

12. Elektronische Vorrichtung (10) nach Anspruch 10, wobei die Gehäuseanordnung (100) eine Seitenwand (116) umfasst, die an einem Außenumfang der Anzeigeanordnung (100b) angeordnet ist, das Aufnahmedurchgangsloch (112) in der Seitenwand (116) definiert ist, das Kunststoffelement (120) in dem Aufnahmeloch (112) angeordnet und fest mit der Seitenwand (116) verbunden ist und die Abdeckschicht (130) das Aufnahmeloch (112) und das Kunststoffelement (120) bedeckt und die Abdeckschicht (130) aus einem keramischen Material hergestellt ist.

## Revendications

1. Ensemble coque (100), comprenant :
un substrat (110) comportant une surface d'affichage, dans lequel un trou de réception pénétrant (112) est défini dans le substrat (110), et une ouverture du trou de réception (112) est située sur la surface d'affichage ;
un élément en plastique (120) disposé dans le trou de réception (112) et fixé à demeure au substrat (110) ; et
une couche de recouvrement (130) recouvrant la totalité de la surface d'affichage et protégeant l'ouverture du trou de réception (112) située sur la surface d'affichage,
dans lequel l'ensemble coque (100) comprend en outre une unité d'espacement (140) disposée entre la surface d'affichage et la couche de recouvrement (130), l'unité d'espacement (140) protégeant l'ouverture du trou de réception (112) située sur la surface d'affichage,
dans lequel l'unité d'espacement (140) comprend une couche d'isolation (142) disposée entre la surface d'affichage et la couche de recouvrement (130), et une couche d'espacement (144) disposée entre la couche d'isolation (142) et la couche de recouvrement (130), **caractérisé en ce que**,
la couche d'espacement (144) a une densité inférieure à celle de la couche d'isolation (142).

2. Ensemble coque (100) selon la revendication 1, dans lequel le substrat (110) est réalisé en matériau métallique, éventuellement, la couche de recouvrement (130) est réalisée en matériau céramique, et éventuellement, la couche de recouvrement (130) a une épaisseur dans la plage de 40 µm à 300 µm.

3. Ensemble coque (100) selon la revendication 1, dans lequel une pluralité de trous de réception (112) qui sont espacés les uns des autres et une pluralité d'éléments en plastique (120) disposés dans la pluralité de trous de réception (112) en correspondance biunivoque sont prévues, et l'ouverture de chaque trou de la pluralité de trous de réception (112) situés sur la surface d'affichage est protégée par la couche de recouvrement (130) .

4. Ensemble coque (100) selon la revendication 1, dans lequel l'unité d'espacement (140) est réalisée en un matériau choisi parmi au moins un parmi le nitrure d'aluminium, l'oxyde d'aluminium, le nitrure de silicium, le dioxyde de silicium, le nitrure de titane, le carbure de silicium, le carbure de titane ou le carbure de chrome.

5. Ensemble coque (100) selon la revendication 1, dans lequel la couche d'isolation est réalisée en un matériau choisi parmi au moins un parmi le nitrure d'aluminium, l'oxyde d'aluminium, le nitrure de silicium, le dioxyde de silicium, le nitrure de titane, le carbure de silicium, le carbure de titane ou le carbure de chrome ; et
éventuellement, la couche d'espacement (144) est réalisée en un matériau choisi parmi au moins un parmi le nitrure d'aluminium, l'oxyde d'aluminium, le nitrure de silicium, le dioxyde de silicium, le nitrure de titane, le carbure de silicium, le carbure de titane ou le carbure de chrome.

6. Ensemble coque (100) selon la revendication 5, dans lequel la couche d'isolation (142) a une épaisseur dans la plage de 0,01 µm à 5 µm ;
éventuellement, la couche d'espacement (144) a une épaisseur dans la plage de 0,5 µm à 50 pm.

7. Ensemble coque (100) selon l'une quelconque des revendications 1 à 6, comprenant en outre un film fonctionnel (150) agencé sur un côté de la couche de recouvrement (130) orienté à l'opposé du substrat (110).

8. Procédé de fabrication d'un ensemble coque (100), comprenant :
la fourniture d'un substrat (110) ayant une surface d'affichage, dans lequel un trou de réception pénétrant (112) est défini dans le substrat (110), et une ouverture du trou de réception (112) est située sur la surface d'affichage ;
la disposition d'un élément en plastique (120) dans le trou de réception (112), dans lequel l'élément en plastique (120) est fixé à demeure au substrat (110) ; et
la formation d'une couche de recouvrement (130) sur la surface d'affichage pour obtenir l'ensemble coque (100), la couche de recouvrement (130) protégeant l'ouverture du trou de réception (112) située sur la surface d'affichage,
dans lequel ladite formation de la couche de recouvrement (130) sur la surface d'affichage comprend :
la formation d'une unité d'espacement (140) sur la surface d'affichage en adoptant un procédé de dépôt, dans lequel l'unité d'espacement (140) est conçue pour protéger l'ouverture du trou de réception (112) située sur la surface d'affichage ; et
la pulvérisation d'un matériau céramique sur l'unité d'espacement (140) pour former la couche de recouvrement (130), dans lequel la couche de recouvrement (130) est située sur un côté de l'unité d'espacement (140) orienté à l'opposé du substrat (110), et
dans lequel ladite formation de l'unité d'espacement (140) sur la surface d'affichage en adoptant le procédé de dépôt comprend :
la formation d'une couche d'isolation (142) sur la surface d'affichage en adoptant un procédé de dépôt physique en phase vapeur ; et
la formation d'une couche d'espacement (144) sur la couche d'isolation (142) en adoptant un procédé de dépôt chimique en phase vapeur pour obtenir l'unité d'espacement (140), dans lequel la couche d'espacement (144) est située sur un côté de la couche d'isolation (142) orienté à l'opposé de la surface d'affichage,
**caractérisé en ce que** la couche d'espacement (144) a une densité inférieure à celle de la couche d'isolation (142) .

9. Procédé de fabrication de l'ensemble coque (100) selon la revendication 8, dans lequel ladite formation de la couche de recouvrement (130) sur la surface d'affichage comprend :
la pulvérisation d'un matériau céramique sur la surface d'affichage pour former la couche de recouvrement (130) .

10. Dispositif électronique (10), comprenant :
l'ensemble coque (100) selon l'une quelconque des revendications 1 à 7 ou l'ensemble coque (100) préparé par le procédé de fabrication de l'ensemble coque (100) selon la revendication 8 ou 9 ;
un ensemble d'affichage (100b) relié à l'ensemble coque (100), dans lequel un espace de montage est défini entre l'ensemble d'affichage (100b) et l'ensemble coque (100) ; et
une carte de circuit imprimé disposée dans l'espace de montage et connectée électriquement à l'ensemble d'affichage (100b).

11. Dispositif électronique (10) selon la revendication 10, comprenant en outre une antenne logée dans l'espace de montage, l'antenne étant proche du trou de réception (112) .

12. Dispositif électronique (10) selon la revendication 10, dans lequel l'ensemble coque (100) comprend une paroi latérale (116) agencée sur une périphérie externe de l'ensemble d'affichage (100b), le trou de réception pénétrant (112) est défini dans la paroi latérale (116), l'élément en plastique (120) est disposé dans le trou de réception (112) et fixé à demeure à la paroi latérale (116), et la couche de recouvrement (130) recouvre le trou de réception (112) et l'élément en plastique (120), et la couche de recouvrement (130) est réalisée en matériau céramique.
